Europäisches Patentamt

European Patent Office

Office européen des brevets

(11) Publication number: **0 303 741**
**A1**

## EUROPEAN PATENT APPLICATION

(21) Application number: 87307145.0

(22) Date of filing: 12.08.87

(51) Int. Cl.⁴: **G09F 9/33 , H01L 33/00 , H01L 25/04**

(43) Date of publication of application:
22.02.89 Bulletin 89/08

(84) Designated Contracting States:
**DE ES GB IT NL**

(71) Applicant: Chen, Shen-Yuan
37 Chung Shan Rd., Sec. 2
Chung Ho City Taipei Hsien(TW)

(72) Inventor: Chen, Shen-Yuan
37 Chung Shan Rd., Sec. 2
Chung Ho City Taipei Hsien(TW)

(74) Representative: Crawford, Andrew Birkby et al
A.A. THORNTON & CO. Northumberland
House 303-306 High Holborn
London WC1V 7LE(GB)

(54) Quickly formable light emitting diode display and its forming method.

(57) The invention relates to light emitting diode display in the form of an array, dot matrix or number-shaped segments. First, many lenses (30) are formed by ejection at one time, which keep a definite interval from each other; then continuous punching and cutting are applied, as well as pressing and encasing the whole, to make the lenses (30) align and be encased into the pre-arranged holes (21) on the display case (20) and also to encase the reflector (40) so that all the lenses (30) are held and clamped between the display case (20) and the reflector (40). Finally a circuit board (50) with light emitting chips welded on it is encased and is firmly fixed together with the display.

FIG.2

EP 0 303 741 A1

# QUICKLY FORMABLE LIGHT EMITTING DIODE DISPLAY AND ITS FORMING METHOD

The invention relates to a kind of light emitting diode updating new construction of array, dot matrix or segmented display and its quickly forming method.

The conventional light emitting diode array, dot matrix or segmented display consists of a generally white and reflective display with many holes poured into with diffusion epoxy. A circuit board is adhered at the bottom of the display and each light emitting chip of the said circuit board is kept exactly at the center of the hole in which the resin has the function of insulation and diffusing light. However, it is not allowed to have any impurity or bubble otherwise the light intensity will be uneven.

As the light emitted by the light emitting chip cannot be entirely reflected by the hole wall, quite a few light will penetrate the hole wall to diffuse around and the surface between holes has dim light. In order to correct such drawbacks and to strength visual contrast between hole and display, the display surface, according to conventional manufacturing art, must be printed with opaque printing ink to shield the dim light inside the surface. (so called light leak or diaphaneity)

As the adjacent displays are hardly combined tightly during combination, the side of one display is usually higher than the adjacent display and its display effectiveness is reduced. For high-quality reflector, it is necessary to print non-transparent printing ink on the sides of the display i.e. the five faces of the display must be printed by turns.

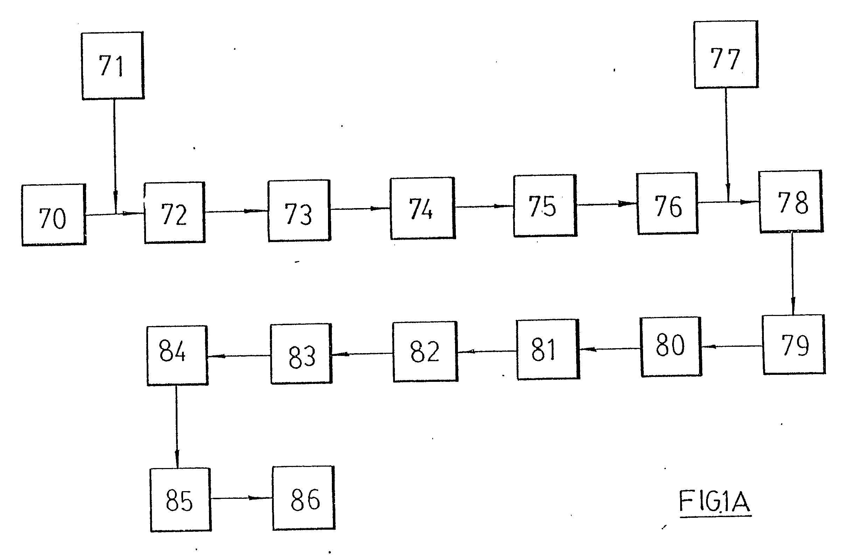

The conventional flow chart of manufacturing light emitting diode (LED) display by traditional method is shown in Fig. 1A. Reference numeral 70 indicates the case for the display, 71 denotes the step of mixing the ink for printing on the case at step 72. At step 73 the cleaning is carried out and adhesive tape is applied, the tape being rubbed and pressed at 74 to remove any bubbles. Step 75, the assembly is baked and at step 76 is inspected and cleaned. 77 denotes the step if preparation of a resin which is poured into the case at 78. 79 denotes the step of preheating, at 80 bubbles are sucked out, 81 a centrifugal force is applied to remove any remaining small bubbles. 82 is a further inspection step. At 83 a circuit plate is pressed into the back of the display, at 84 a coating of resin is applied, 85 denotes a further baking step and at 86 the adhesive tape is removed. Obviously, the process of manufacturing conventional LED display is rather tedious, and since the time of various operations is in big difference bottlenecks are aroused in the production line and the efficiency of the production is very hard to upgrade, furthermore, during the process of filing resin into display holes, it is substantially very hard to get rid of bubbles or impurities in the resin, that affect the light intensity in the LED display. In case of discovery that, during inspection after manufacture, the light intensity of chip in one hole is different from that in other holes, it is unable to disassemble for correction because of the hardened resin in holes and of the chip on circuit board adhered firmly with it. Consequently the hole product cannot but be discarded and the various parts cannot be re-used.

It is an objective of the invention to provide the construction of a newly combined LED display. It is another objective of the invention to provide a new method for quick combination of LED display. It is still another objective of the invention to provide a LED display of which defective items can be repaired and replaced at any time. It is the last objective of the invention to provide a LED display of which light intensity can be enhanced. The most obvious industrial values, which the conventional LED display cannot satisfy, of the manufacturing method of the invention are as follows:

(1) Improving the conventional manual art into semi-automatic manufacturing art, therefore, the productive flow is simplified and the production speed is upgraded.

(2) According to conventional manufacturing method, all constructive items of display which is discovered to be defective at the final inspection of light intensity can not be reworked and must be discarded altogether. But in the invention, defective items can be dismantled immediately for repair or replacement. The conventional serviceable rate is roughly kept at 80%-85% and 88% by careful control, while the serviceable rate of this invention can reach to over 98%.

(3) The bottle neck (delay & waiting) of production line can be reduced by this invention. Owing to prolonged producting flow in conventional art. (some processes take 5 seconds and some others take 4 hours) There are many waiting bottlenecks, but there is no bottlenecks in this invention since it makes form by quick combination after various constructive items formed.

(4) The light source is concentrated since the light emitted by the light emitting chip of this invention cannot diffuse around and is reflected by the plating layer, and the light intensity of this product is up-graded if comparing with the conventional light emitting chips of the same class. As the diaphaneity lens has arc surface with light convergence function, the light intensity is upgraded and the diffusion angle of light may be changed with the curvature of an arc surface.

(5) The product of this invention being unnecessary to get through the process of printing, may have any colors printed on the surface as required and which won't be damaged or faded even after used for a long period or suffered abrasion.

Fig. 1A shows sequential steps in the fabrication of conventional LED display.

Fig. 1B shows sequential steps in fabrication of the display by this invention.

Fig. 2 is the perspective exploded view of the preferred embodiment 1 of this invention and shows various diaphaneity lenses are still combined with ribs.

Fig. 3 is the display perspective exploded view of the preferred embodiment 1 of this invention and shows various diaphaneity lenses are apart from ribs.

Fig. 4 is the sectional view taken along 4-4 in Fig. 3 and shows the construction of various parts after combination.

Fig. 5 is the partially enlarged view of Fig. 4.

Fig. 6 is the perspective exploded view of the embodiment 2 of this invention.

Fig. 7 is the partially sectional view taken along 7-7 in Fig. 6 and shows the construction of various parts after combination.

Fig. 8 is the perspective exploded view of the embodiment 3 of this invention.

Fig. 9 is the sectional view taken along 9-9 in Fig. 8 and shows the construction of various parts after combination.

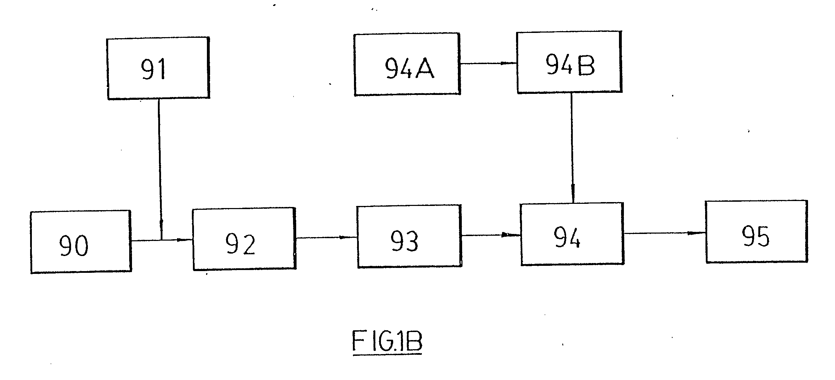

The manufacturing art of this invention is shown in Fig. 1B. The Bowl-shaped cases formed by pre-ejection are put into the lower mold of a punch machine (step 90). Then a set of lenses formed by pre-ejection and supported by interconnected ribs is put at the top of the case. The ribs interconnecting lenses are cut by molding tools (step 91) so that the lenses fall into the diaphanous holes of the case and is combined to the case by pressing (step 92). A reflector is encased (step 93) at the back of cases combined with lenses, and further a circuit board which was prefabricated and got through inspection, glue-sprayed (step 94A) and baked (step 94B) is also encased (step (94), so that the case and the circuit board are firmly fixed by proper art, and that the display is formed completely (step 95).

Above art can be applied to array, not matrix and segmented displays. The preferred embodiments are as follows:

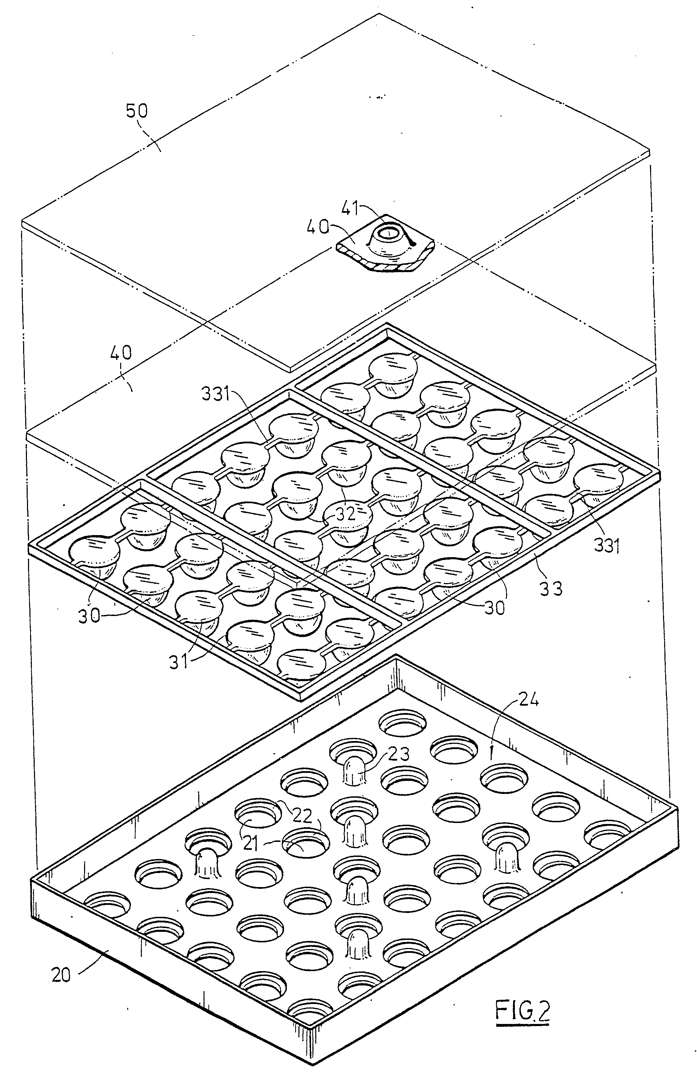

Please refer to Figs. 2, 3, 4 and 5 which show the dot or dot matrix displays made by this invention which consists of a case 20, some lenses 30, a reflector 40 and a circuit board 50. Each trough item is pre-formed as shown in the exploded view in Fig. 2 in which:

The inverting bowl-shaped case 20 has some holes which is generally matrix type such as 5 x 7 diaphaneity holes 21 and there are more than two positioning posts 23 in its shallow trough 24. The whole body of case 20 is formed by ejection of any opaque colour plastics, each hole 21 is a typical countsink that has an annular shoulder 22 for encasing lenses 30; some dot-shaped lenses 30 in the same quantity as holes 21 of the case 20 are formed by ejection of plastics with high diaphaneity such as PC acryl. At the bottom of each lens 30 there is a shoulder 31. Both ends of lens 30 are plane or convex arc surface in the shape of a bulb lens which is with light convergence effect.

A reflector 40 formed by ejection of typical ABS plastics has some eddy-shaped holes 41 in the same quantity as holes 21 of case 20 and more than two positioning holes 42 symmetric with case 20. Before combination, the reflector 40 will be plated completely with a layer of metal film 43 or only on the portion of eddy-shaped hole 41. The position on the circuit board 50, being symmetric with hole 21 of case 20, will be coated with yellow or yellow green light reflecting thin film 53 to construct light reflecting background of light emitting chips 51, and be welded with some chips 51, and then be sprayed with resin thin film to prevent oxidation and to fix the chips firmly. On the circuit board 50, there are also positioning holes 52 against positioning posts 23 of case 20.

As shown in Fig. 2, the above-mentioned lenses, before combination, have configuration in the same quantity and interval as holes 21 of cases 20 have and are rejected together on a rib-shaped support 33, of which the rib 331 connecting with lens 30 is comparatively tiny.

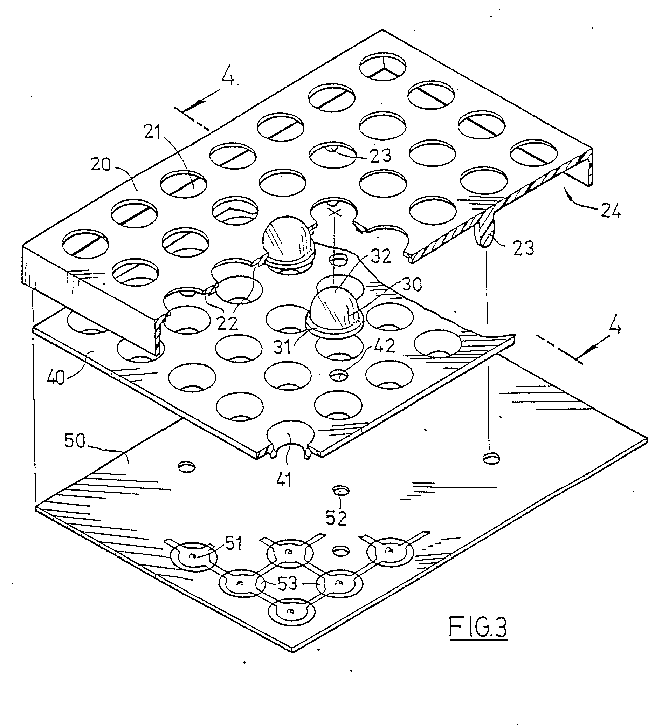

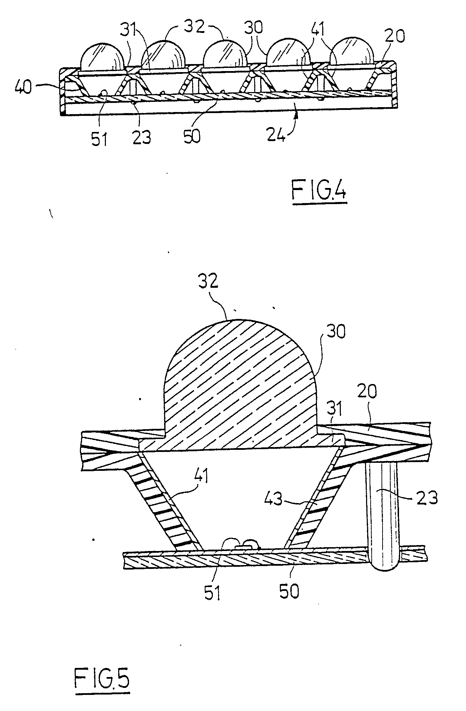

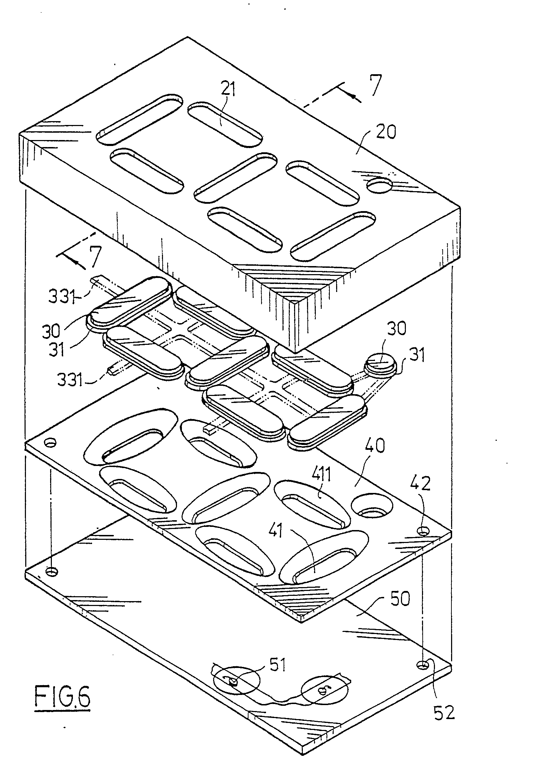

The art of manufacturing LED display in this invention is that, the bowl-shaped case 20 is put facing upward with its shallow trough facing upward, then the dot-shaped lenses 30 preformed together with rib-shaped support 33 are put on it, then both are sent into molding tools for punch and cut, and lenses 30, as shown in Fig. 3, after being cut apart, may be entirely pressed into holes 21 of case 20 at the same time, but not to place them one by one. Then the remaining rib-shaped support 33 are withdrawn. After that the preformed and plated reflectors 40, by virtue of aligning and encasing the positioning hole 42 with positioning post 23 of case are pressed on the various lenses, and together with that the positioning holes 52 of the circuit board 50 are aligned with positioning post 23 of case 20 and then are encased, thus, the light emitting chips 51 will be kept in the eddy-shaped holes 41 of reflector 40 and finally by melting. The end of positioning post 23 various constructive items will be speedily fixed to combine a LED display. The construction after combination is shown in Figs. 4 and 5.

Embodiment 2

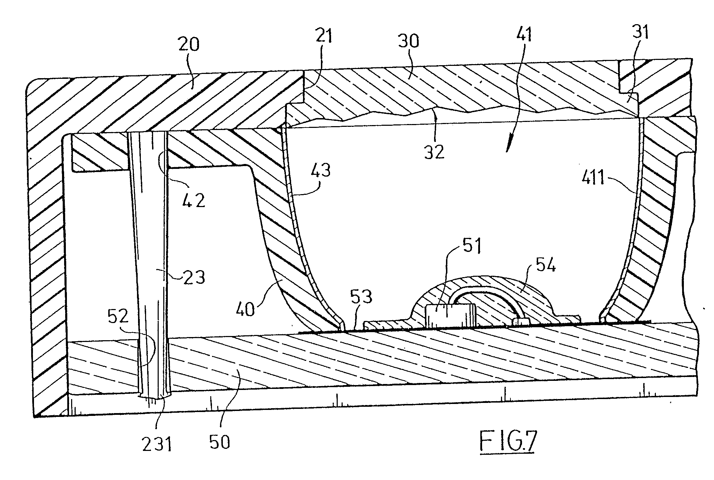

This embodiment shows the application of the manufacturing art of this invention to the manufacture of segmented display. As shown in Fig. 6, the various lenses 30 formed by pre-ejection are also kept by virtue of rib 31 in the arrangement relationship of 8-type.

On case 20, there are four each vertical and horizontal long holes 21 to construct a 8-type hole. There may be a single 8-type hole or some sets of long holes forming multiple 8-type holes on the case 20. The bottom edge of lenses 30 may be in the construction of an arch-shaped arc surface 32 so as to enable the light emitting chips 51 on circuit board 50 to converge light during emitting light. Furthermore, the arc surface can be constructed by connecting deflection surfaces i.e. diamond-shaped multiple surfaces to upgrade light deflection effectiveness. The upper edge of lenses 30 is a frosted glass surface 34 constructed by some intensive arc surfaces or deflection surfaces, therefore, the light converged and deflected originally in lenses 30 may become mild because of the evenly dispersion of getting through the frosted glass surface 34.

As the construction in embodiment 1, there is a reflector 40 at the back of lens 30 on which there are holes 41 similar to the long hole 21 of case 20, and between holes 41 there are arc-shaped hole wall 411 coating on thin metal film 43.

As shown in Fig. 6, the various lenses 30 kept originally on an ejection body are put in the punch machine to cut the lenses 30 and the ribs 331 around apart, so that the lenses 30 will fall into the long holes 21 of case 20 and reflector 40 is encased so as to insert and clamp various lenses 30 between the reflector 40 and the case 20. Then the circuit board 50 coated with a yellow green light reflecting film 53 at the position where aligning the central position of the long hole 21 of case 20 is encased, and a light emitting chip 51 is welded. After weld the chips 51 must be sprayed and coated with re⁻ film 54 dried and solidificated by process of slightly baked to prevent oxidation and to upgrade adhering effectiveness.

After the circuit board 50 treated by above processes, and put at the back of reflector 40, use adhesive glue slightly to stick them both, or as shown if Fig. 7, use the virtue of the positioning posts 23 of case 20 penetrating in sequence through the positioning holes 42 of reflector 40 and the positioning holes 52 of circuit board 50; and then by the virtue the end 231 of the positioning post 23 melt for expansion by heated gradually, circuit board 50 cannot be taken apart from case 20 easily unless the end portion 231 is heated to melt.

Therefore, the circuit board 50 in the display made by this invention can be taken apart from case 20 to replace chip 51, if any problems such as uneven light intensity are discovered in the display during final inspection, and the inspection and repairment of this reflector are made easy.

Embodiment 3

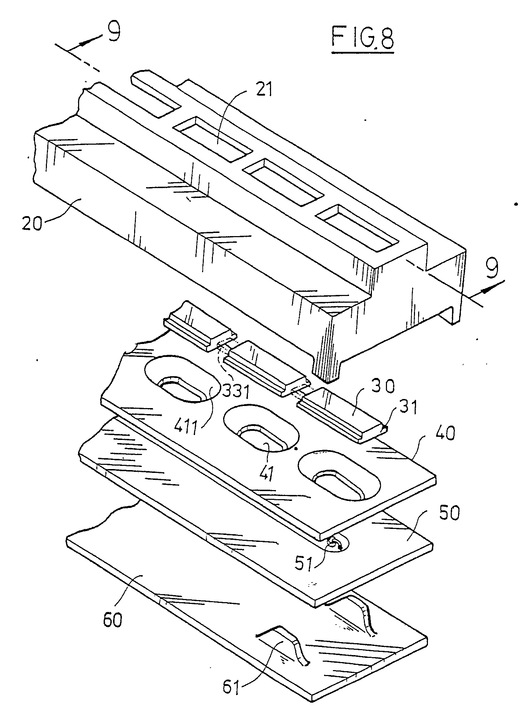

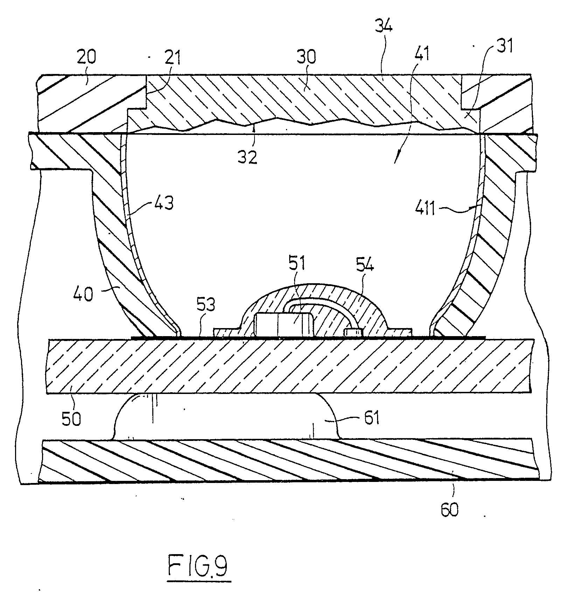

The construction and forming art of this embodiment may be applied to array-type display in the same way. As shown in Figs. 8 and 9, the array-type case 20 has holes 21 for diaphaneity in its shallow bowl-shaped trough 24 and is formed by rejection together. After the lenses 30 keeping a definite distance by supporting ribs 331 are cut off by punch machine, the lenses 30 fall into holes 21 of case 21, and then a reflector 40 and a circuit board 50 is encased in sequence. The above said construction and forming art are generally the same as that of the embodiments 1 and 2.

The duplicate figure of this embodiment shows an art in which a kind cases 20, lenses 30, reflectors 40 and circuit boards 50 are combined into a display. In addition to the art using the virtue of encasing positioning post to positioning holes in embodiments 1 and 2, there is still a better art i.e. adding an additional cover 60, being about the same size as case 20 and having flange 61 on it, to the back of circuit board 50, and after various constructive items are encased into the shallow trough 25 of case 20, encasing the cover 60 with case 20. Either appling glue or heating high frequent wave for melting may be applied to where being around the cover 60 and case 20 to make the flange 61 cover 60 support the back of circuit board 50. Thus, the circuit board 50, reflector 40 and various lenses are hold firmly between the flange 61 and the case 20.

Claims

1. A kind of quick forming art for forming light emitting display of which the bowl-shaped case is faced upward and some lenses maintained by rib-shaped supports are put in the back of it, then which is sent into molding tools for punching and cutting, so that after ribs between lenses are cut apart each diaphaneity lens will be precisely encased into the pre-arranged holes on the case, and next, the pre-formed reflector and the circuit board welded with light emitting chips will be encased via case back in sequence to combine a display.

2. A combined light emitting diode display comprising:
an inverted bowl-shaped case with holes;
lenses in the same quantity as that of the case, which are with a shoulder at the bottom for hooking against the hole side of the case when lenses encased into case holes;
a reflector with holes in the same number as that of the case holes;
a circuit board welded with light emitting chips in the same amount as that of the case holes.

3. A combined light emitting diode display according to claim 2, further comprising a plated mental film in the hole wall of said reflector.

4. A combined light emitting diode display according to claim 2, further comprising a yellow reflecting film around the light emitting chips of the said circuit board.

5. A combined light emitting diode display according to claim 2, comprising countersinks on said reflector.

6. A combined light emitting diode display according to claim 2, further comprising positioning posts in the shallow trough of said case back:
positioning holes of said reflector generally aligning the positioning posts of said case and positioning holes of said circuit board generally aligning the positioning posts of said case.

7. A combined light emitting diode display according to claim 2, further comprising a cover encased on the back of said case to construct a closed space between said case and said cover.

8. A combined light emitting diode display according to claim 2, comprising round holes on said reflector.

9. A combined light emitting diode display according to claim 2, comprising long holes on said reflector.

10. A combined light emitting diode display accord ing to claim 2, comprising holes of said reflector arranged in matrix.

11. A combined light emitting diode display according to claim 2, comprising holes of said reflector arranged in 8-type segmented.

12. A combined light emitting diode display according to claim 2, comprising holes of the reflector arranged in array.

13. A combined light emitting diode display according to claim 2, comprising arc-shaped hole walls on said reflector.

14. A combined light emitting diode display according claim 2, comprising cone-shaped holes on said reflector.

15. A combined light emitting diode display according to claim 7, further comprising flange on the cover to support the back of said circuit board.

FIG1A

EP 0 303 741 A1

FIG.1B

FIG.2

FIG.3

FIG.4

FIG.5

FIG.6

FIG.7

EP 0 303 741 A1

EP 0 303 741 A1

FIG.8

FIG.9

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 345 308  (A. MOUYARD) <br> * Abstract; figure 1 * <br> --- | 1-8,10, 13 | G 09 F   9/33 <br> H 01 L   33/00 <br> H 01 L   25/04 |
| A | WO-A-8 001 860  (AMP) <br> * Figure 2; abstract * <br> --- | 1,2,10 | |
| A | EP-A-0 127 239  (RTC) <br> * Claims; figures 1-4 * <br> --- | 1-3,8, 10,13 | |
| A | US-A-3 918 053  (H. TOWNE et al.) <br> * Column 3, line 14 - column 4, line 46; figure 1 * <br> --- | 1,2 | |
| A | FR-A-2 524 155  (RTC) <br> * Claims; figures 1-4 * <br> --- | 1,2,8, 10,13 | |
| A | US-A-4 225 380. (J. WICKENS) <br> * Column 2, line 63 - column 3, line 26; figure 1 * <br> --- | 1,2,8, 10,13 | |
| A | US-A-4 603 496  (W. LATZ) <br> * Column 2, line 15 - column 4, line 5; figures 1-3 * <br> --- | 1,2,8, 10,12, 13 | TECHNICAL FIELDS SEARCHED (Int. Cl.4) <br><br> G 09 F <br> H 01 L |
| A | DE-A-2 929 809  (SANYO) <br> * Claims * <br> ----- | 1,2,11 | |

The present search report has been drawn up for all claims

| Place of search | Date of completion of the search | Examiner |
|---|---|---|
| THE HAGUE | 29-02-1988 | GALLO G.G. |